# EUROPEAN PATENT APPLICATION

(11) **EP 4 187 584 A2**
(43) Date of publication of application: **31.05.2023**
(21) Application number: 22209582.0
(22) Date of filing: 25.11.2022
(51) Int. Cl.: H01L 21/8234, H01L 29/78, H01L 29/417, H01L 29/66

(54) **TRANSISTOR STRUCTURE**

(30) Priority: 26.11.2021 US 202163283322 P
(71) Applicant: Invention And Collaboration Laboratory Pte. Ltd., Singapore 068914 (SG)
(72) Inventor: Lu, Chao-Chun, 106 Taipei City (TW); Huang, Li-Ping, 106 Taipei City (TW)
(74) Representative: Straus, Alexander

(57) **Abstract**

A transistor structure includes a substrate, an isolation wall, and a gate region. The substrate has a fin structure. The isolation wall clamps sidewalls of the fin structure. The gate region is above the fin structure and the isolation wall; wherein the isolation wall is configured to prevent the fin structure from collapsing.

## Description

### Field of the Invention

The present invention relates to a transistor structure according to claims 1, 9, 15, 19.

### Background of the Invention

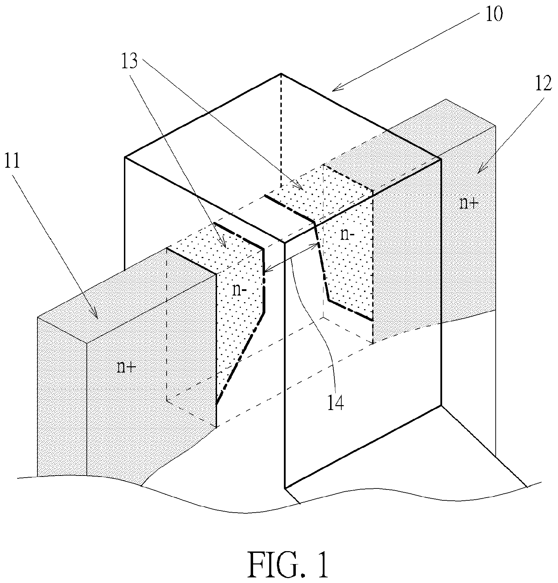

An example of state-of-the-art field-effect transistor (e.g. an NMOS (N-type metal-oxide-semiconductor) transistor) with FIN-structure (FinFET or Tri-gate) is shown in FIG. 1. A gate structure 10 of the NMOS transistor using some conductive material (like metal, polysilicon, or polyside, etc.) over an insulator (such as oxide, oxide/nitride, or some high-k dielectric, etc.) is formed on a three-dimensional (3D) silicon surface whose sidewalls are isolated from those of other transistors by using insulation materials (e.g. oxide or oxide/nitride or other dielectrics). A source 11 and a drain 12 of the NMOS transistor are formed by an ion-implantation plus thermal annealing technique to implant high concentration n-type (n+) dopants into a p-type substrate (or a p-well) which thus results in two separated n+/p junction areas.

Furthermore, to lessen impact ionization and hot carrier injection prior to highly doped n+/p junction, it is common to form lightly doped-drains (n- LDDs) 13 before the source 11 and the drain 12 by ion-implantation plus thermal annealing technique, and such ion-implantation plus thermal annealing technique frequently causes the LDDs 13 penetrating into the portion of the 3D active regions which are underneath the gate structure 10 (as shown in FIG.1). Therefore, an effective channel length 14 between the LDDs 13 is unavoidably shortened.

On the other hand, the advancement of manufacture process technologies is continuing to move forward rapidly by scaling down the geometries of the NMOS transistor in both horizontal and vertical dimensions (such as the minimum feature size called as Lamda (λ) is shrunk from 28nm down to 5nm or 3nm). But many problems are introduced or getting worse due to such FinFET or Tri-gate geometry scaling:
(1) As the both horizontal and vertical dimensions are scaled down, it's getting harder to align the LDD junction edge (or source/drain edge) to the edge of gate structure 10 in a perfect position by only using the conventional self-alignment method of using gate, spacer and ion-implantation formation. In addition, the thermal annealing technique for removing the ion-implantation damages must count on high temperature processing techniques such as rapid thermal annealing method by using various energy sources or other thermal processes. One problem thus created is that a gate-induced drain leakage (GIDL) current and the GIDL current issued is hard to be controlled regardless the fact that it should be minimized to reduce leakage currents; the other problem as created is that a length of the effective channel 14 is difficult to be controlled and so the short channel effect (SCE) is hardly minimized. Additionally, it is also difficult to adjust the relative position between the source/drain edge to the edge of the gate structure 10 such that the GIDL could be controlled.
(2) In addition, since the ion-implantation to form the LDDs 13 (or the n+/p junction in NMOS or the p+/n junction in PMOS (p-type metal-oxide-semiconductor)) works like bombardments in order to insert ions from a top of a silicon surface straight down to the substrate, it is hard to create uniform material interfaces with lower defects from the source 11 and the drain 12 to the effective channel 14 and the substrate-body regions since the dopant concentrations are non-uniformly distributed vertically from the top surface with higher doping concentrations down to the junction regions with lower doping concentrations.
(3) Furthermore, when the horizontal dimension is scaled down to 7nm, 5nm or 3nm, the height (the vertical dimension) of the fin structure (such as 60~300nm) of the NMOS transistor is far larger than a width (the horizontal dimension) of the fin structure (such as 3~7nm) of the NMOS transistor such that the fin structure is vulnerable or even collapsed during the following processes (such as source/drain formation, gate formation, etc.).

Therefore, the present invention provides a transistor structure to solve the above-mentioned 1)-3) problems.

### Summary of the Invention

The present invention aims at providing a transistor structure that can form a solid wall (wherein additional beam-like structure(s) could be provided to strengthen the solid wall) to clamp an active region or a narrow fin structure, especially sidewalls of the fin structure, make relative position or distance between an edge of a source/a drain and an edge of a gate controllable, improve resistance of the source/the drain, and make most the source/drain areas isolated by insulation materials.

This is achieved by a transistor structure according to claims 1, 9, 15, 19. The dependent claims pertain to corresponding further developments and improvements.

As will be seen more clearly from the detailed description following below, the claimed transistor structure. The transistor structure includes a substrate, an isolation wall, and a gate region. The substrate has a fin structure. The isolation wall clamps sidewalls of the fin structure. The gate region is above the fin structure and the isolation wall; wherein the isolation wall is configured to prevent the fin structure from collapsing.

According to one aspect of the present invention, the isolation wall clamps four sidewalls of the fin structure.

According to one aspect of the present invention, the transistor structure further includes a STI layer surrounding the isolation wall.

According to one aspect of the present invention, the transistor structure further includes a sheet channel layer disposed between the sidewalls of the fin structure and the isolation wall, wherein the sheet channel layer is formed by selective epitaxy growth.

According to one aspect of the present invention, the gate region includes a gate dielectric layer over the fin structure substrate, a gate conductive layer over the gate dielectric layer, and a cap layer over the gate conductive layer.

According to one aspect of the present invention, the isolation wall is configured to prevent the fin structure from collapsing during the formation of the gate dielectric layer, the gate conductive layer, and the cap layer.

According to one aspect of the present invention, the transistor structure further includes a spacer layer on a sidewall of the gate region.

According to one aspect of the present invention, the first conductive region is formed in a first concave under an original surface of the substrate.

Another embodiment of the present invention provides a transistor structure. The transistor structure includes a substrate, a composite structure, and a gate region. The substrate has a fin structure. The composite structure clamps sidewalls of the fin structure. The gate region is above the fin structure and the composite structure; wherein the composite structure is configured to prevent the fin structure from collapse.

According to one aspect of the present invention, the composite structure includes a supporting wall clamping the sidewalls of the fin structure and a supporting beam sustaining the supporting wall.

According to one aspect of the present invention, the supporting wall extends in a first direction from a bottom of the fin structure, and the supporting beam extends in a second direction different from the first direction of the supporting wall.

According to one aspect of the present invention, the supporting wall and the supporting beam are made of nitride.

According to one aspect of the present invention, the supporting beam abuts against the supporting wall.

According to one aspect of the present invention, the composite structure includes a supporting wall clamping the sidewalls of the fin structure and a plurality of supporting beams sustaining the supporting wall.

Another embodiment of the present invention includes a transistor structure, the transistor structure includes a substrate with an original surface, a channel region, a gate region above the channel region; a shallow trench isolation region, a first conductive region between the gate region and the shallow trench isolation region, the first conductive region electrically contacting to the channel region, and a metal region between the gate region and the shallow trench isolation region; wherein at least two sides of the first conductive region contact to the metal region.

According to one aspect of the present invention, the shallow trench isolation region extends upward and above the original surface, and the first conductive region is not over the shallow trench isolation region.

According to one aspect of the present invention, the metal region contacts a top surface and a sidewall of the first conductive region.

According to one aspect of the present invention, the transistor structure further includes an L shape isolator under a bottom of the first conductive region.

Another embodiment of the present invention includes a transistor structure, the transistor structure includes a substrate with an original surface, a channel region, a gate region above the channel region, a shallow trench isolation region surrounding the channel region, and a first conductive region electrically contacting to the channel region, wherein a bottom of the gate region is lower than a bottom of the first conductive region.

According to one aspect of the present invention, the bottom of the gate region is over a part of the shallow trench isolation region.

### Brief Description of the Drawings

The present invention is further illustrated by way of example, taking reference to the accompanying drawings thereof:
FIG. 1 is a diagram illustrating a FinFET according to the prior art,
FIG. 2A is a flowchart illustrating a manufacturing method of a fin field-effect transistor (FinFET) according to a first embodiment of the present invention,
FIGS. 2B, 2C, 2D are diagrams illustrating FIG. 2A,
FIG. 3 is a diagram illustrating the pad-oxide layer being grown, the pad-nitride layer being deposited, the trench, and the semiconductor layer being formed, the oxide spacer being deposited on the semiconductor layer, and the nitride spacer being deposited on the oxide spacer,
FIG. 4 is a diagram illustrating the shallow trench isolation (STI) being formed, and the gate area across the active region and the isolation region being defined,
FIG. 5 is a diagram illustrating the gate material being formed, the composite cap layer being deposited, the STI being etched, and the pad-nitride layer being removed,
FIG. 6 is a diagram illustrating the pad-oxide layer being etched away, some portion of the STI being etched back, the oxide-2 spacer and the nitride-2 spacer being formed, and some exposed silicon areas being etched away to create shallow trenches for the source and the drain,
FIG. 7 is a diagram illustrating the oxide-3 layer being thermally grown,
FIG. 8 is a diagram illustrating the oxide-3 layer being etched away, and the source and the drain being formed by the SEG technique,
FIG. 9 is a diagram illustrating the cross-section of the SCBFET, and Y-direction doping concentration and X-direction doping concentration corresponding to the cross-section of the SCBFET,
FIG. 10 is a diagram illustrating the cross-section of the SCBFET being trapezoid shape,
FIG. 11 is a diagram illustrating the cross-section of the SCBFET without the thin sheet-channel layer,
FIGS. 12A, 12B are flowcharts illustrating a manufacturing method of a FinFET according to a second embodiment of the present invention,
FIG. 13 is a diagram illustrating depositing an oxide layer and using the CMP technique to remove the excess oxide layer to form the STI, and depositing a nitride film on the STI,
FIG. 14 is a diagram illustrating forming the STI on the nitride film, defining a gate area across the active region and an isolation region, etching away the pad-oxide layer and the pad-nitride layer corresponding to the gate area, etching back the STI corresponding to the gate area, forming a gate dielectric material and depositing a gate material in a concave, then etching back the gate material, forming a composite cap layer and polishing the composite cap layer,
FIG. 15 is a diagram illustrating etching a part of the STI, removing the pad-nitride layer, etching away the pad-oxide layer, etching back the STI, forming an oxide-2 spacer and a nitride-2 spacer on edges of the gate material and the composite cap layer,
FIG. 16 is a diagram illustrating etching away exposed silicon and growing thermally an oxide-3 layer,
FIG. 17 is a diagram illustrating etching away portion oxide-3 layer, and then forming n-type lightly doped drains (LDDs), and then forming n+ doped source and n+ doped drain,
FIG. 18 is a diagram illustrating a nitride film being deposited several times,
FIG. 19 is a diagram illustrating the merged semiconductor junction and metal conductor (MSMC) structure being formed,
FIG. 20A is a diagram illustrating the merged semiconductor junction and metal conductor (MSMC) structure being formed according to another embodiment of the present invention, and
FIG. 20B is a diagram illustrating the merged semiconductor junction and metal conductor structure being formed according to another embodiment of the present invention,

### Detailed Description

### First embodiment

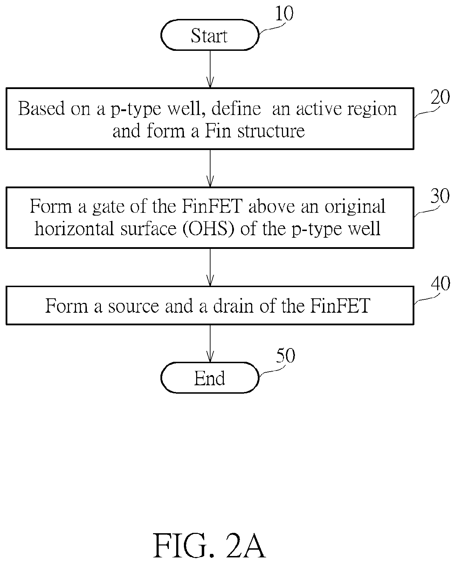

Please refer to FIGS. 2A, 2B, 2C, 2D, 3, 4, 5, 6, 7, 8, 9, 10, 11, wherein FIG. 2A is a flowchart illustrating a manufacturing method of a fin field-effect transistor (FinFET) according to a first embodiment of the present invention, and the manufacturing method of the FinFET in FIG. 2A can make the FinFET have lower gate-induced drain leakage (GIDL) current and lower short channel effect (SCE), and form a solid wall to clamp an active region or a narrow fin structure of the FinFET. Detailed steps are as follows:

| | |
|---|---|
| Step 10: | Start. |
| Step 20: | Based on a p-type well 202, define an active region and form a Fin structure. |
| Step 30: | Form a gate of the FinFET above an original horizontal surface (OHS) of the p-type well 202. |
| Step 40: | Form a source and a drain of the FinFET. |
| Step 50: | End. |

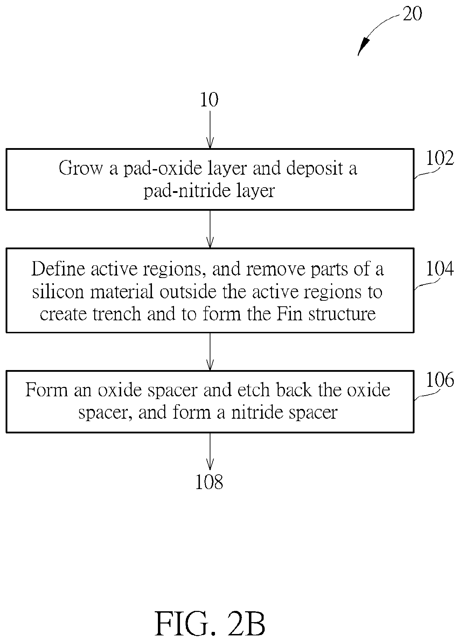

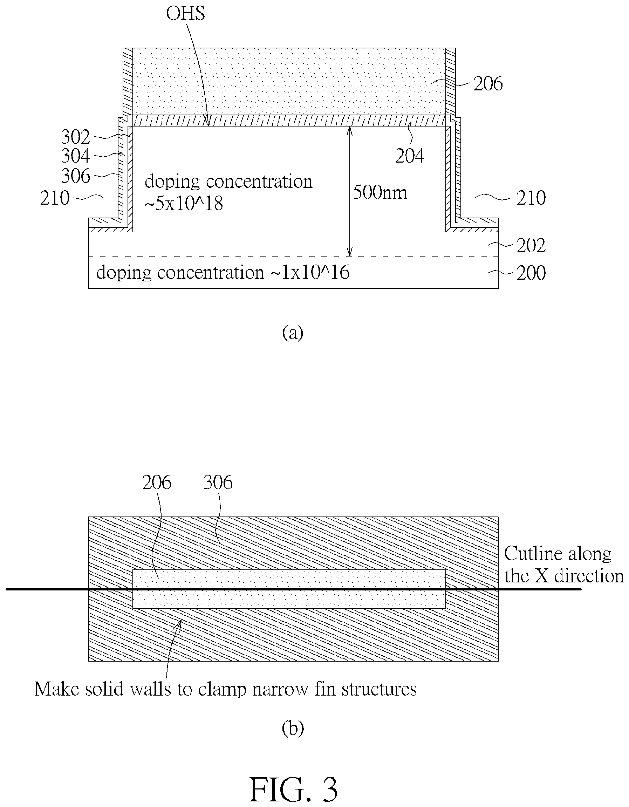

Please refer to FIG. 2B and FIG. 3. Step 20 could include:

| | |
|---|---|
| Step 102: | Grow a pad-oxide layer 204 and deposit a pad-nitride layer 206. |
| Step 104: | Define active regions, and remove parts of a silicon material outside the active regions to create trench 210 and to form the Fin structure. |
| Step 106: | Form an oxide spacer 304 and etch back the oxide spacer 304, and |
| | form a nitride spacer 306 |

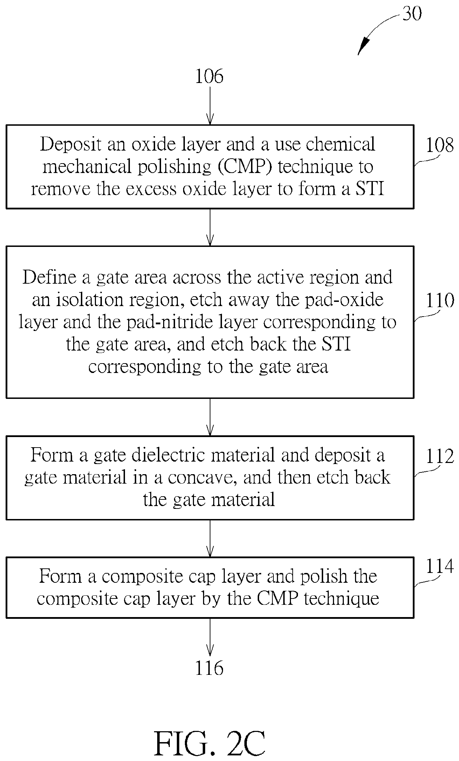

Then, please refer to FIG. 2C and FIGS. 4, 5. Step 30 could include:

| | |
|---|---|
| Step 108: | Deposit an oxide layer and use a chemical mechanical polishing (CMP) technique to remove the excess oxide layer to form a STI 402. |
| Step 110: | Define a gate area across the active region and an isolation region, etch away the pad-oxide layer 204 and the pad-nitride layer 206 corresponding to the gate area, and etch back the STI 402 corresponding to the gate area. |
| Step 112: | Form a gate dielectric material 502 and deposit a gate material 504 in a concave 404, and then etch back the gate material 504. |
| Step 114: | Form a composite cap layer 506 and polish the composite cap layer 506 by the CMP technique. |

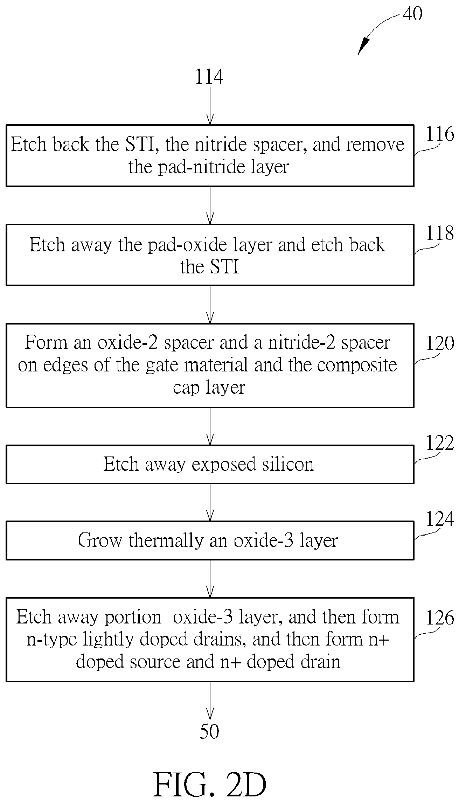

Please refer to FIG. 2D, FIGS. 6, 7, 8. Step 40 could include:

| | |
|---|---|
| Step 116: | Etch back the STI 402, the nitride spacer 306, and remove the pad-nitride layer 206. |
| Step 118: | Etch away the pad-oxide layer 204 and etch back the STI 402. |
| Step 120: | Form an oxide-2 spacer 802 and a nitride-2 spacer 804 on edges of the gate material 504 and the composite cap layer 506. |
| Step 122: | Etch away exposed silicon. |
| Step 124: | Grow thermally an oxide-3 layer 1002. |
| Step 126: | Etch away portion oxide-3 layer 1002, and then form n-type lightly doped drains (LDDs) 1102, 1104, and then form n+ doped source 1106 and n+ doped drain 1108. |

Detailed description of the aforesaid manufacturing method is as follows. Start with the well-designed doped p-type well 202, wherein the p-type well 202 is installed in a p-type substrate 200 (wherein in another embodiment of the present invention, could start with the p-type substrate 200, rather than starting with the p-type well 202), wherein in one example the p-type well 202 has its top surface counted down about 500nm thick from the OHS and has higher concentration close to 5×10^18 dopants/cm^3 (for example) than that of being used in state-of-the-art FinFETs having been lighter doped substrate (even including a punch-through implantation dopant profile). In addition, for example, the p-type substrate 200 has lower concentration close to 1×10^16 dopants/cm^3. The actual dopant concentrations will be decided by final mass production optimizations. As a result, the p-type substrate voltage (which is usually Grounded, i.e. 0 V) can be supplied across most of the body of the FinFET, rather than causing mostly depleted Fin substrate (which behaves like a voltage-floated body that is hardly controlled or stabilized, and less desired in contrast to the semiconductor transistor with a voltage stable body).

In Step 102, as shown in FIG. 3(a), grow the pad-oxide layer 204 with well-designed thickness over the OHS and deposit the pad-nitride layer 206 with well-designed thickness on a top surface of the pad-oxide layer 204.

In Step 104, as shown in FIG. 3(a), use a photolithographic masking technique to define the active regions of the FinFET by an anisotropic etching technique, wherein the anisotropic etching technique removes parts of a silicon material corresponding to the OHS outside the active regions to create the trench 210 (e.g. about 300nm deep) for future STI (shallow trench isolation) needs, such that the fin structure of the FinFET is created as well. In addition, FIG. 3(b) is a top view corresponding to FIG. 3(a), wherein FIG. 3(a) is a cross-section view along a cutline of an X direction shown in FIG. 3(b).

In Step 106, as shown in FIG. 3(a), use a selective growth method, such as selective epitaxial growth (SEG) technique, to grow the semiconductor layer 302 (hereinafter named as sheet-channel layer (SCL), and the SCL could be a monolithic p-type doped silicon about 1 to 2 nm thickness which should be well adjusted for detailed device design) over the exposed silicon surfaces (two sidewalls of the fin structure and the top surfaces of bottom areas of the trench 210). In another example, this sheet-channel layer (SCL) is optional. Deposit the oxide spacer 304 on the semiconductor layer 302, and use the anisotropic etching technique to etch back the oxide spacer 304 to make a top surface of the oxide spacer 304 is in level up to the OHS. Then, deposit the nitride spacer 306 on the oxide spacer 304, and a top surface of the nitride spacer 306 is in level up to a top surface of the pad-nitride layer 206. In addition, the oxide spacer 304 and the nitride spacer 306 are outside the active region of the FinFET. Thus, the key point here is that the oxide spacer 304 and then the nitride spacer 306 form a solid wall to clamp the active region or the narrow fin structure, especially the sidewalls of the fin structure. The solid clamping wall could be a single layer or other composite cap layers to protect the narrow fin structure from collapse during the forming the source/the drain or the gate of the FinFET.

The another key point here is that the semiconductor layer 302 will be used for the channel region (which will be turned into a depleting region until being fully inverted to a channel conduction region which depends upon how the gate voltage is applied) of the FinFET. So the doping concentration of the semiconductor layer 302 will affect the threshold voltage of the FinFET and form the major conductive layer with electron carriers under inversion for connecting both the n-type source and the n-type drain. As the SEG layer 302 is formed separately from the bulk body of the FinFET, the most desirable design is to have suitably lower doping concentration (e.g. 1×10^16 to 3×10^18) than that of the Fin body so that the channel conductive condition from OFF to ON changed from depletion to inversion is mostly occurred inside the semiconductor layer 302 with being less affected due to more stable voltage conditions of the bulk body of the FinFET. In addition, the semiconductor layer 302 would also strengthen the Fin's mechanical stability as the Fin has been proportionally made thinner and taller as the feature size (i.e. dimension of the line) is continued to be scaled down horizontally. The taller Fin can increase the device width (to compensate the reduction of the carrier mobility due to undesirable channel collisions as the Fin becomes narrower) but may cause the physical collapse of some narrow Fins.

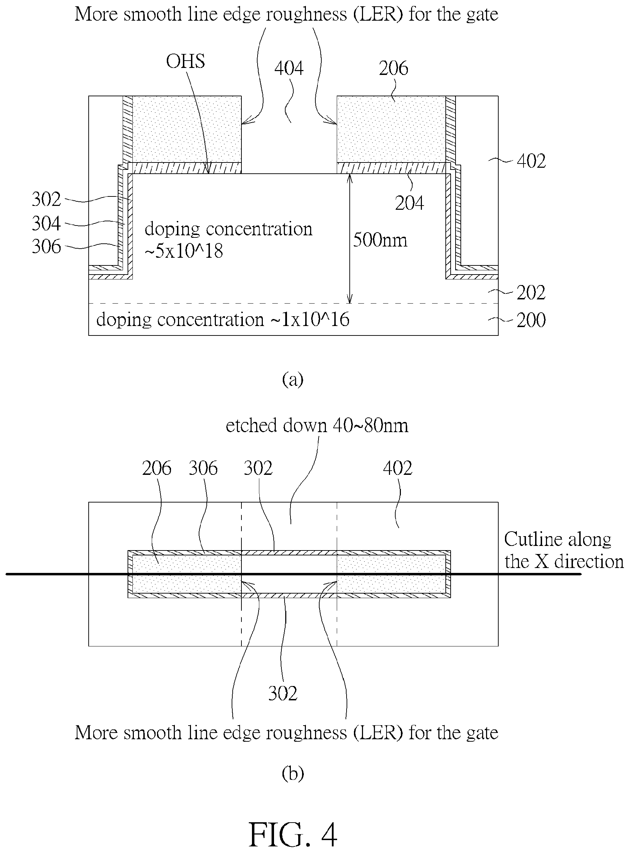

In Step 108, as shown in FIG. 4(a), deposit the thick oxide layer to fully fill the trench 210 and use the CMP technique to remove the excess oxide layer to form the STI 402, wherein a top surface of the STI 402 is in level up to a top surface of the pad-nitride layer 206. Again, the STI 402 further encompasses or clamp the active region or the narrow fin structure, especially the sidewalls of the fin structure, to protect the narrow fin structure from collapse during the forming the source/the drain or the gate of the FinFET. In addition, FIG. 4(b) is a top view corresponding to FIG. 4(a), wherein FIG. 4(a) is a cross-section view along a cutline of an X direction shown in FIG. 4(b).

In Step 110, as shown in FIG. 4(a), then use the photolithographic masking technique to define the gate area across the active region and the STI isolation region so that the pad-oxide layer 204 and the pad-nitride layer 206 corresponding to the gate area are removed to create the concave 404. Moreover, the STI 402 corresponding to the gate area is also etched down by a certain amount (e.g. 40∼80nm deep) to form a step structure between the fin surface and the etched STI region correspond to the gate area. The oxide spacer 304 and the nitride spacer 306 correspond to the gate area could be removed as well. Thus, an upper portion of the semiconductor layer 302 is exposed, and a smooth line edge roughness for the gate of the FinFET is provided.

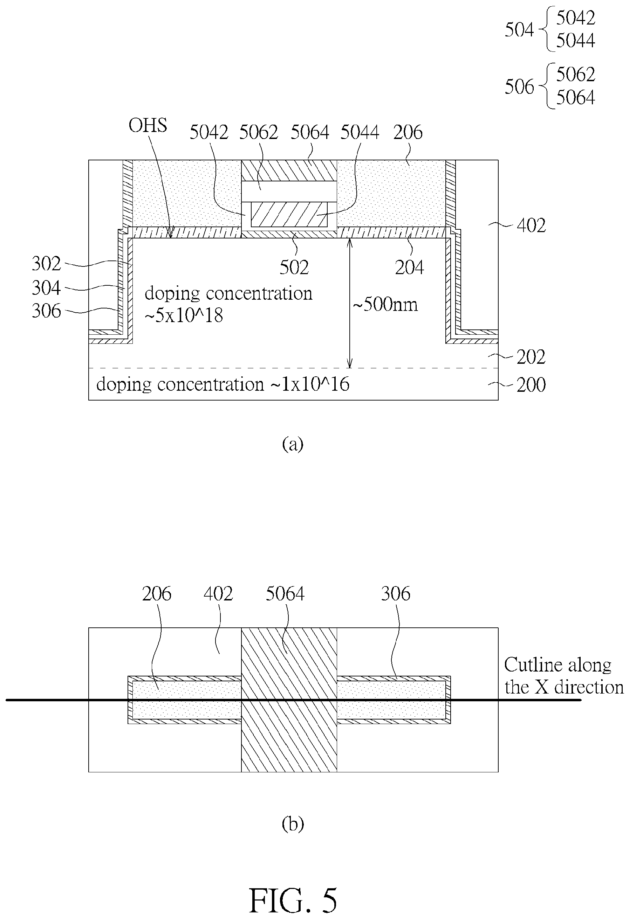

In Step 112, as shown in FIG. 5(a), the gate dielectric material 502 (composite materials or oxide) is formed in the concave 404 (also the step structure between the fin surface and the etched STI 402 corresponding to the gate area) and the gate material 504 (e.g. metal like Tungsten 5044 over TiN 5042) is deposited above the gate dielectric material 502. Then the gate material 504 is polished by the CMP technique to make a top surface of the gate material 504 in level up to the top surface of the remained pad-nitride layer 206, and etch back the gate material 504 to make the top surface of the gate material 504 below the top surface of the remained pad-nitride layer 206. Thus, there could be a tri-gate structure.

In Step 114, as shown in FIG. 5(a), then deposit the composite cap layer 506 composed of a nitride-1 layer 5062 and a Hardmask-oxide layer 5064 into the concave 404 on the top surface of the gate material 504, wherein the composite cap layer 506 is used for protecting the gate material 504. Then, the composite cap layer 506 is polished by the CMP technique to make a top surface of the composite cap layer 506 in level up to the top surface of the pad-nitride 206. In addition, FIG. 5(b) is a top view corresponding to FIG. 5(a), wherein FIG. 5(a) is a cross-section view along a cutline of an X direction shown in FIG. 5(b).

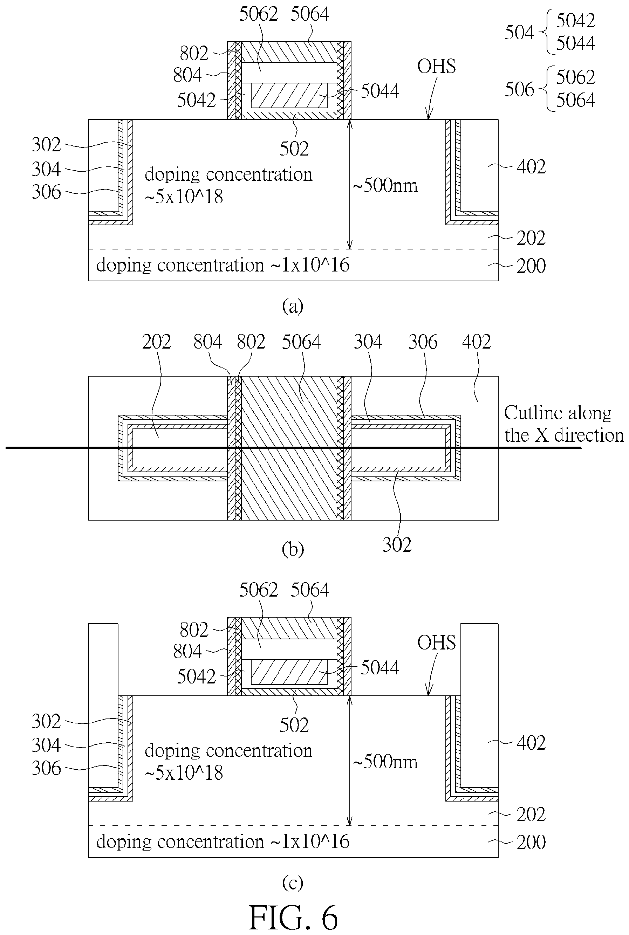

In Step 116, as shown in FIG. 6(a), etch the STI 402 and the nitride spacer 306, and remove the pad-nitride layer 206 to make a top surface of the STI 402 in level up to the top surface of the pad-oxide layer 204.

Similarly, up to Step 116, the two semiconductor layers 302 (sheet-channel layer, SCL) are formed on two sidewalls of the Fin (wherein the two semiconductor layers 302 are named as Qleft and Qright, respectively) but a top surface of the Fin structure does not have the SCL, so the threshold voltage of the upper MOSFET (Qtop) with higher doping concentrations may be thus higher than those of two sidewalls of the FinFET).

In Step 118, as shown in FIG. 6(a), etch away the pad-oxide layer 204 and etch back some portion of the STI 402.

In Step 120, as shown in FIG. 6(a), then deposit an oxide-2 layer to form the oxide-2 spacer 802 and a nitride-2 layer to form the nitride-2 spacer 804 on the edges of the gate material 504 and the composite cap layer 506. In addition, FIG. 6(b) is a top view corresponding to FIG. 6(a), wherein FIG. 6(a) is a cross-section view along a cutline of an X direction shown in FIG. 6(b).

In another example, it is possible to remove the pad-nitride layer 206 and keep the STI 402, such that the STI 402 still surrounds the Fin structure. Then the pad-oxide layer 204 is etched away, so is portion of the STI 402, such that the remaining STI 402 has a top surface still higher than the OHS, as shown in FIG. 6(c). Thus, the fin structure is surrounded by the remaining STI 402 which has a top surface higher than the OHS.

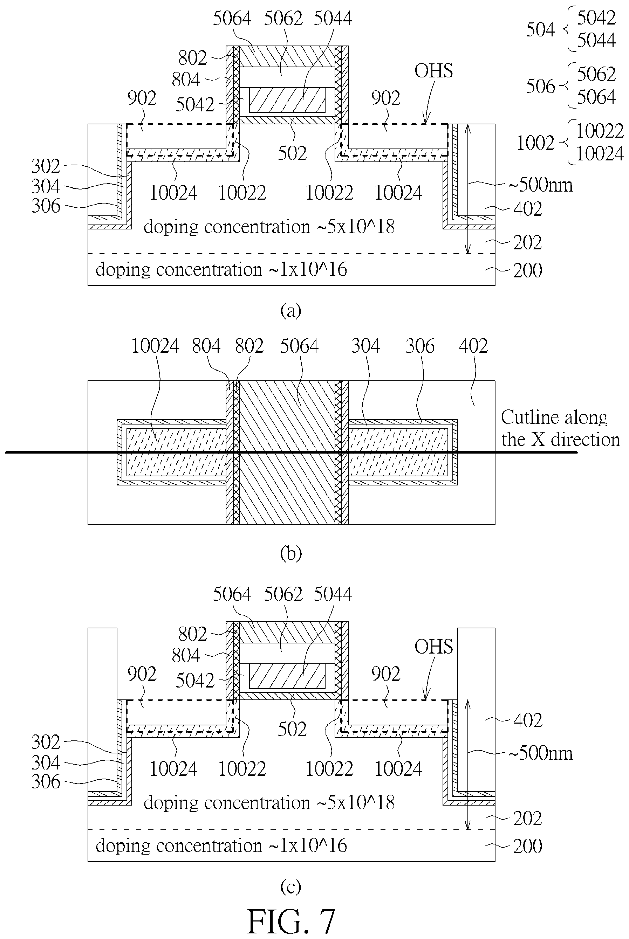

In Step 122, as shown in FIG. 7(a), then etch away some exposed silicon areas to create shallow trenches 902 for the source and the drain (e.g. about 50nm deep) of the FinFET.

In Step 124, as shown in FIG. 7(a), use a thermal oxidation process, called as an oxidation-3 process, to grow the oxide-3 layer 1002 (including both an oxide-3V layer 10022 penetrating the vertical sidewalls of the bulk body of the FinFET (assuming with a sharp crystalline orientation (110)) and an oxide-3B layers 10024 on the top surface of the bottoms of the shallow trenches 902). Since two sidewalls of the shallow trenches 902 have vertical composite materials of the oxide-2 spacer 802 and the nitride-2 spacer 804, and the other sidewalls of the shallow trenches 902 is against the oxide spacer 304 and the nitride spacer 306, the width of the source/drain of the FinFET is not really affected by such thermal oxidation process. In addition, the thickness of the oxide-3V layer 10022 and the oxide-3B layer 10024 drawn in FIG. 7 and following figures are only shown for illustration purpose, and its geometry is not proportional to the dimension of the STI 402 shown in those figures. For example, the thickness of the oxide-3V layer 10022 and the oxide-3B layer 10024 is around 20~30 nm, but the vertical height of the STI 402 could be around 200∼250 nm.

But it is very important to design the oxidation-3 process such that the thickness of oxide-3V layer 10022 can be very accurately controlled under both precisely controlled thermal oxidation temperature, timing and growth rate. Since the thermal oxidation over a well-defined silicon surface should result in that 40% of the thickness of the oxide-3V layer 10022 is taken away the thickness of the exposed (110) silicon surface in the vertical wall of the FinFET body and the remaining 60% of the thickness of the oxide-3V layer 10022 is counted as an addition outside the vertical wall of the FinFET body (such a distribution of 40% and 60% on the oxide-3V layer 10022 relative to the oxide-2 spacer 802/the nitride-2 spacer 804 is particularly drawn clearly by dash-lines in FIG. 7 since its importance will be further articulated in the following text). In addition, FIG. 7(b) is a top view corresponding to FIG. 7(a), wherein FIG. 7(a) is a cross-section view along a cutline of an X direction shown in FIG. 7(b). In addition, FIG. 7(c) shows another example for the oxidation-3 process based on structure in FIG. 6(c).

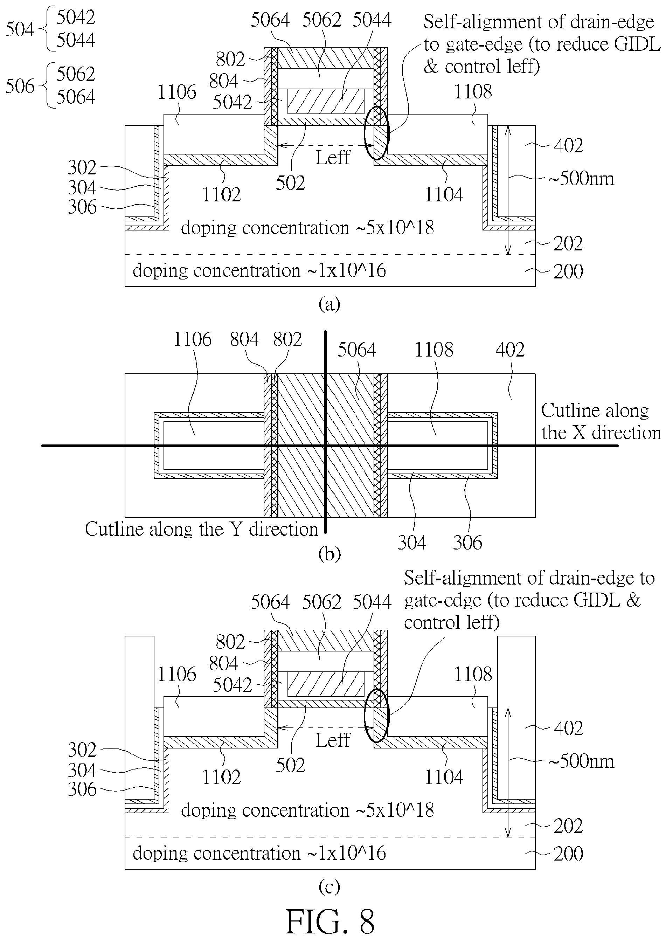

In Step 126, as shown in FIG. 8(a), first etch away the oxide-3 layer 1002. Then use the selective growth method, such as the SEG technique, to form the n-type LDD 1102, 1104 and then to form the n+ doped source 1106 and the n+ doped drain 1108. Therefore, the major portion of the FinFET has been completed. In addition, FIG. 8(b) is a top view corresponding to FIG. 8(a), wherein FIG. 8(a) is a cross-section view along a cutline of an X direction shown in FIG. 8(b). In addition, FIG. 8(c) shows another example for the selective growth process based on structure in FIG. 7(c). As shown in FIG. 8(c), since the fin structure is surrounded by the remaining STI 402 which has a top surface higher than the OHS, during the selective growth of source/drain regions, the selectively grown source/drain regions will be confined by the remaining STI 402 and will not be over the remaining STI 402.

Moreover, It is noticed that, in one example, the bottom of the gate structure on the STI region (not shown) could be lower than the bottom of the drain/source region about 10∼20nm.

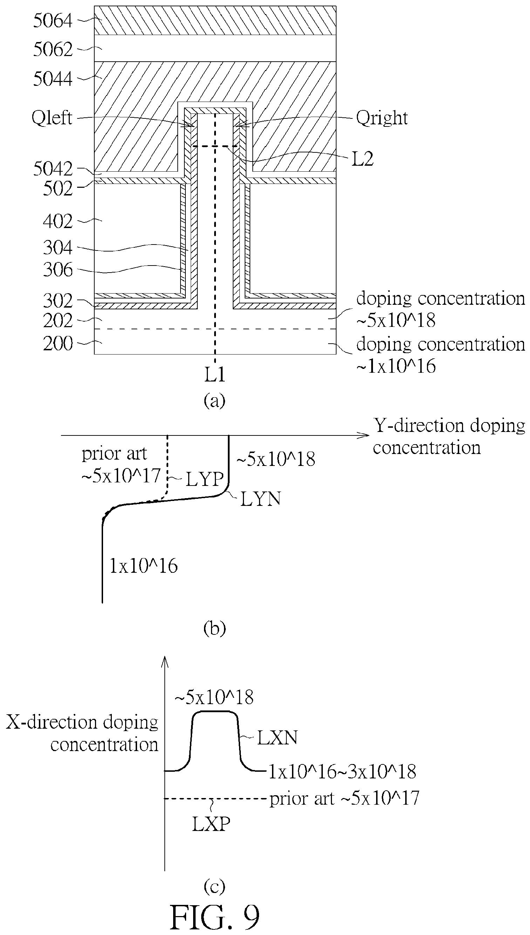

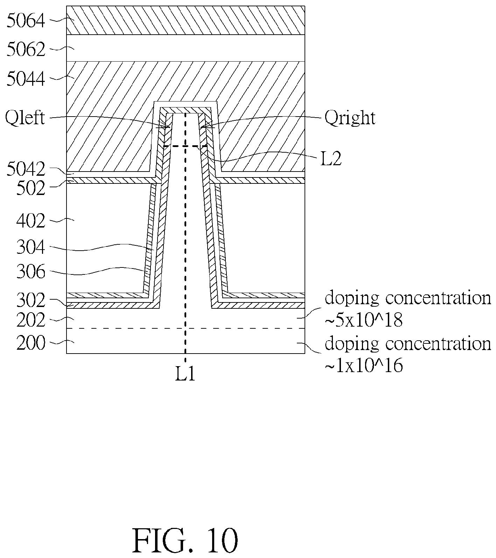

Please refer to FIG. 9. FIG. 9(a) is a cross-section view along a cutline of a Y direction shown in FIG. 8(b). As shown in FIG. 9(a), on the cross-section view, it's clear to see both the Qleft and the Qright which are SEG grown p-type doped silicon channel region. As shown in FIG. 9(b), there are Y-direction concentration profile LYN and Y-direction concentration profile LYP of the prior art, wherein the Y-direction concentration profile LYN corresponds to a dash line L1 marked in FIG. 9(a). Similarly, as shown in FIG. 9(c), there is X-direction concentration profile LXN and X-direction concentration profile LXP of the prior art, wherein the X-direction concentration profile LXN corresponds to a dash line L2 marked in FIG. 9(a). It is clear that the doping concentration of the Qleft and the Qright (e.g. 1×10^16 to 3×10^18) is lower than that (e.g. 5×10^18) of the Fin body of the FinFET. In addition, in another embodiment, as shown in FIG. 10, the fin structure can be etched as trapezoid shape for better short channel effect control. Furthermore, in another embodiment, the fin body could be undoped.

The major invention points are described in the following. Since both the drain and the source of the FinFET are formed by the SEG technique except they are doped with n-type dopants in concentrations higher than that of the Qleft and the Qright, both well-created seamless contact regions between the drain and the channel and between the source and the channel, respectively, have been well formed. No ion-implantations for forming all channels, the drain and the source are completed and no high temperature thermal annealing is necessary to remove those damages due to heavy bombardments of forming the drain and the source. Moreover, the solid wall (such as the oxide spacer 304 and then the nitride spacer 306 shown in FIG. 3) to clamp the active region or the narrow fin structure, especially the sidewalls of the fin structure. The solid clamping wall could be a single layer or other composite cap layers to protect the narrow fin structure from collapse during the forming the source/the drain or the gate of the FinFET. Furthermore, the STI 402 (shown in FIG. 4) further encompasses or clamp the active region or the narrow fin structure, especially the sidewalls of the fin structure, to protect the narrow fin structure from collapse during the forming the source/the drain or the gate of the FinFET. Thus, even the height of the fin structure (such as 60~300nm) is far larger than the width of the fin structure (such as 3~7nm) of the FinFET, the fin structure protected by the solid wall of the present invention is unlikely vulnerable during the following processes (such as the source/the drain formation, gate formation, etc.).

As shown in FIG. 6, another advantage of the present invention is that, since the thickness of the oxide-2 spacer 802 and the nitride-2 spacer 804 formed on the edges of the gate region (i.e. the gate material 504 and the composite cap layer 506) is controllable, and the thickness of the oxide-3V layer 10022 and the oxide-3B layer 10024 made by the thermal oxidation process (shown in FIG. 7) is controllable as well, the edge of the source/the drain could be aligned or substantially aligned with the edge of the gate region (as shown in FIG. 8), especially the source/the drain is formed by the SEG technique. Thus, according to the present invention, the relative position or distance between the edge of the source/the drain and the edge of the gate region is controllable, and could be dependent on the thickness of spacer formed on the edges of the gate region and/or the thickness of the oxide layer (such as the oxide-3V layer 10022 shown in FIG. 7 although the oxide-3V layer 10022 is removed in FIG. 8). Therefore, an effective channel length Leff (shown in FIG. 8) could be controlled such that the gate-induced drain leakage (GIDL) current issue could be improved.

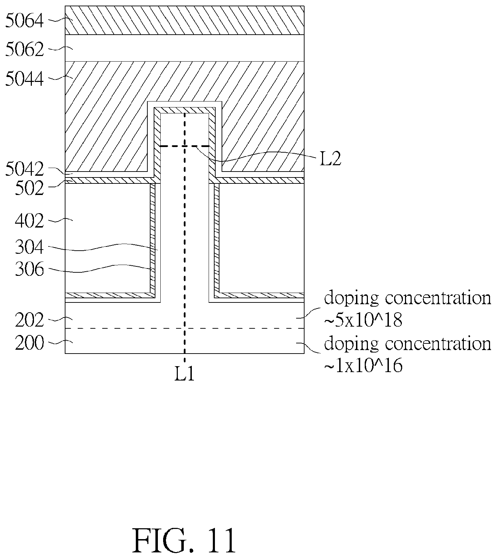

In another embodiment, the selective epitaxial growth (SEG) technique to grow a thin sheet-channel layer (the semiconductor layer 302) of monolithic p-type doped silicon shown in FIG. 3 is not required, but the solid wall (such as the oxide spacer 304 and the nitride spacer 306 shown in FIG. 3) is still formed to clamp the active region or the narrow fin structure, especially the sidewalls of the fin structure. Then, the similar processes in FIG. 4 to FIG. 8 without the thin sheet-channel layer (the semiconductor layer 302) could be performed to form another fin structure (as shown in FIG. 11). Of course, in another embodiment, the fin structure can be etched as trapezoid shape for better short channel effect control. Again, as shown in FIG. 11, even the height of the fin structure (such as 60~300nm) is far larger than the width of the fin structure (such as 3~7nm), the fin structure of this embodiment protected by the solid wall is unlikely vulnerable during the following processes (such as the source/the drain formation, gate formation, etc.). The relative position or distance between the edge of the source/the drain and the edge of the gate region is controllable, and could be dependent on the thickness of spacer formed on the edges of the gate region and/or the thickness of the oxide layer (such as the oxide-3V layer 10022 shown in FIG. 7). Therefore, the effective channel length Leff could be controlled such that the GIDL current issue could be improved.

### Second embodiment

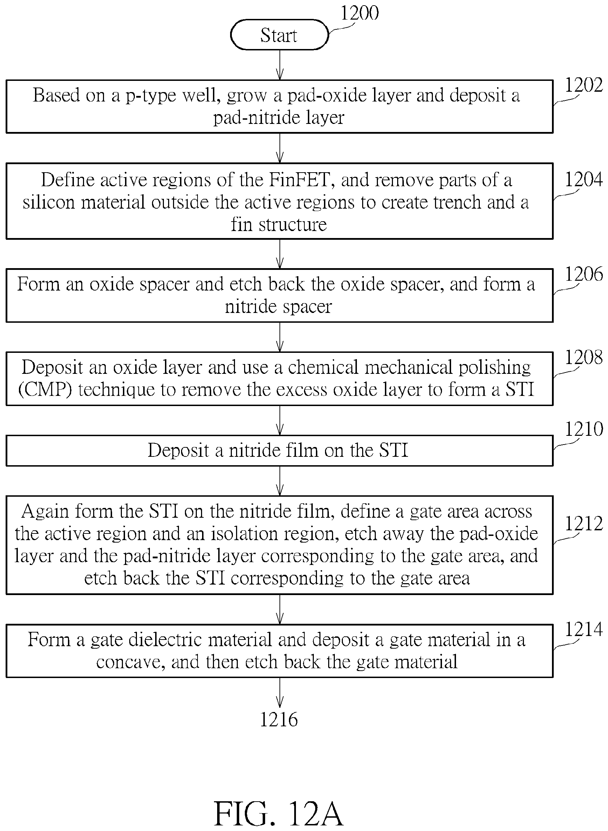

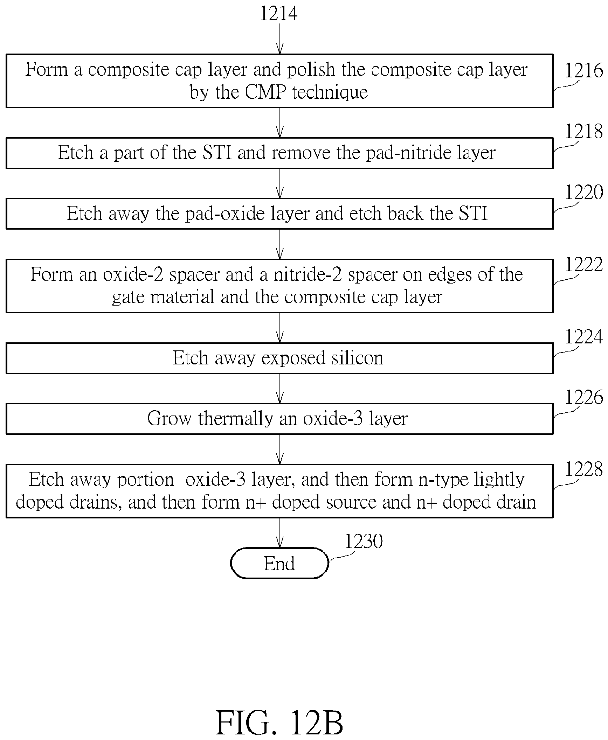

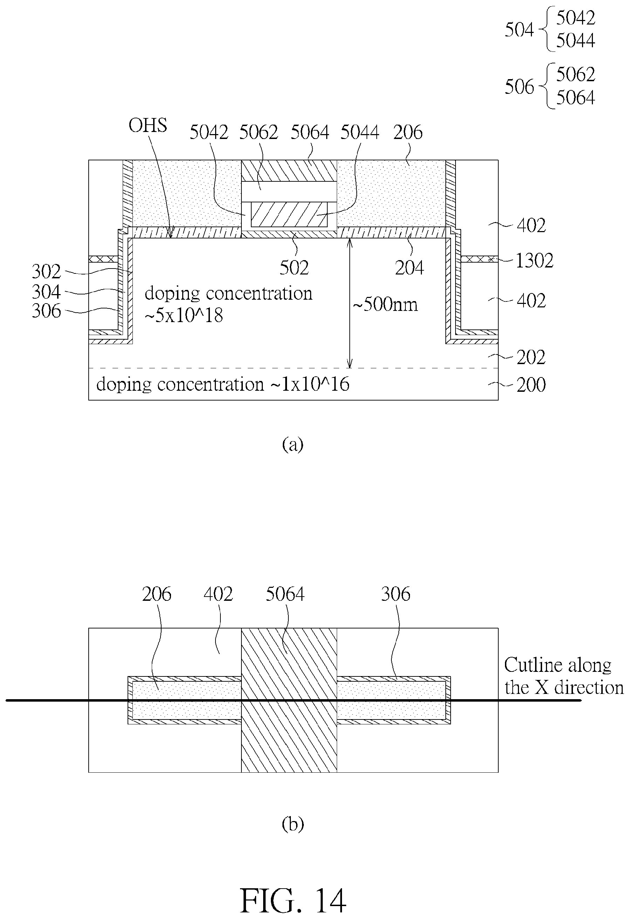

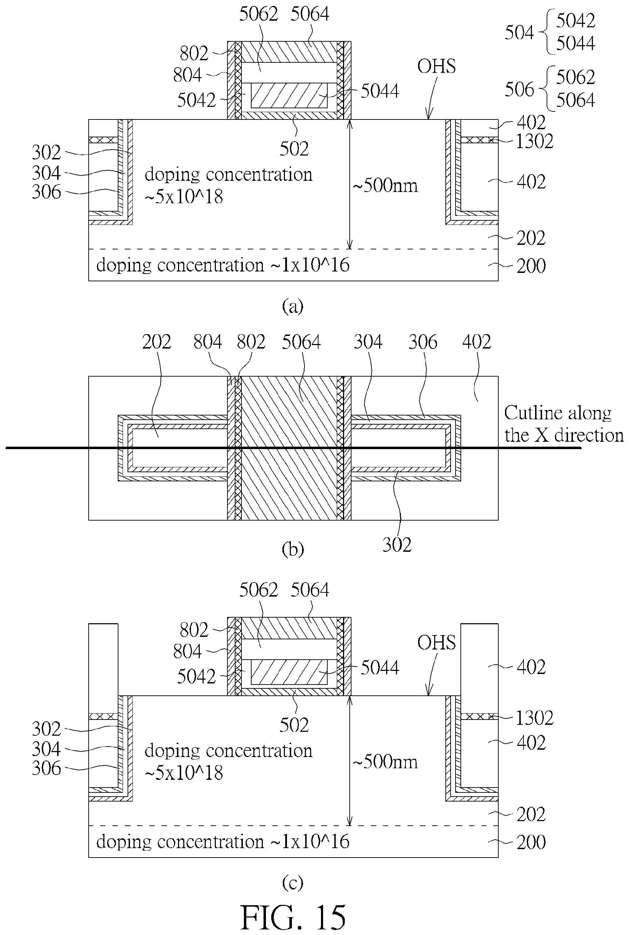

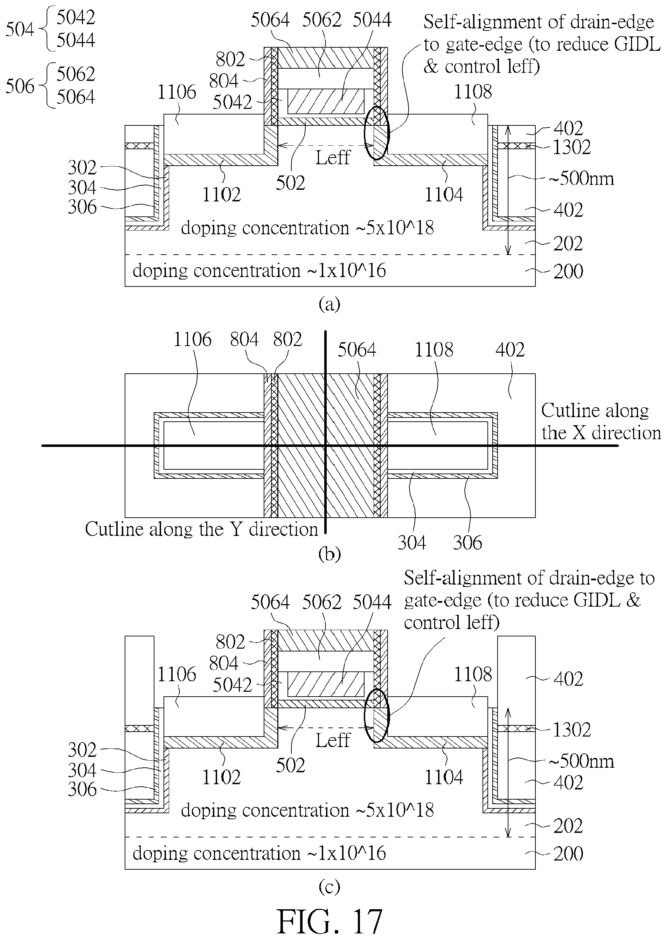

Please refer to FIGS. 12A, 12B, 13, 14, 15, 16, 17, wherein FIGS. 12A, 12B are flowcharts illustrating a manufacturing method of a FinFET according to a second embodiment of the present invention, and the manufacturing method of the FinFET in FIGS. 12A, 12B can make the FinFET also have lower gate-induced drain leakage (GIDL) current and lower short channel effect (SCE), and form a solid wall to clamp an active region or a narrow fin structure of the FinFET. Detailed steps are as follows:

| | |
|---|---|
| Step 1200: | Start. |
| Step 1202: | Based on a p-type well 202, grow a pad-oxide layer 204 and deposit a pad-nitride layer 206 (shown in FIG. 3). |
| Step 1204: | Define active regions of the FinFET, and remove parts of a silicon material corresponding to the OHS outside the active regions to create trench 210 (shown in FIG. 3) and a fin structure. |
| Step 1206: | Form an oxide spacer 304 and etch back the oxide spacer 304, and form a nitride spacer 306 (shown in FIG. 3). |
| Step 1208: | Deposit an oxide layer and use a chemical mechanical polishing (CMP) technique to remove the excess oxide layer to form a STI 402 (shown in FIG. 13). |
| Step 1210: | Deposit a nitride film 1302 on the STI 402 (shown in FIG. 13). |
| Step 1212: | Again form the STI 402 on the nitride film 1302, define a gate area across the active region and an isolation region, etch away the pad-oxide layer 204 and the pad-nitride layer 206 corresponding to the gate area, and etch back the STI 402 corresponding to the gate area (shown in FIG. 14). |
| Step 1214: | Form a gate dielectric material 502 and deposit a gate material 504 in a concave 404, and then etch back the gate material 504 (shown in FIG. 14). |
| Step 1216: | Form a composite cap layer 506 and polish the composite cap layer 506 by the CMP technique (shown in FIG. 14). |
| Step 1218: | Etch a part of the STI 402 and remove the pad-nitride layer 206 (shown in FIG. 15). |
| Step 1220: | Etch away the pad-oxide layer 204 and etch back the STI 402 (shown in FIG. 15). |
| Step 1222: | Form an oxide-2 spacer 802 and a nitride-2 spacer 804 on edges of |
| | the gate material 504 and the composite cap layer 506 (shown in FIG. 15). |
| Step 1224: | Etch away exposed silicon (shown in FIG. 16). |
| Step 1226: | Grow thermally an oxide-3 layer 1002 (shown in FIG. 16). |
| Step 1228: | Etch away portion oxide-3 layer 1002, and then form n-type lightly doped drains (LDDs) 1102, 1104, and then form n+ doped source 1106 and n+ doped drain 1108 (shown in FIG. 17). |
| Step 1230: | End. |

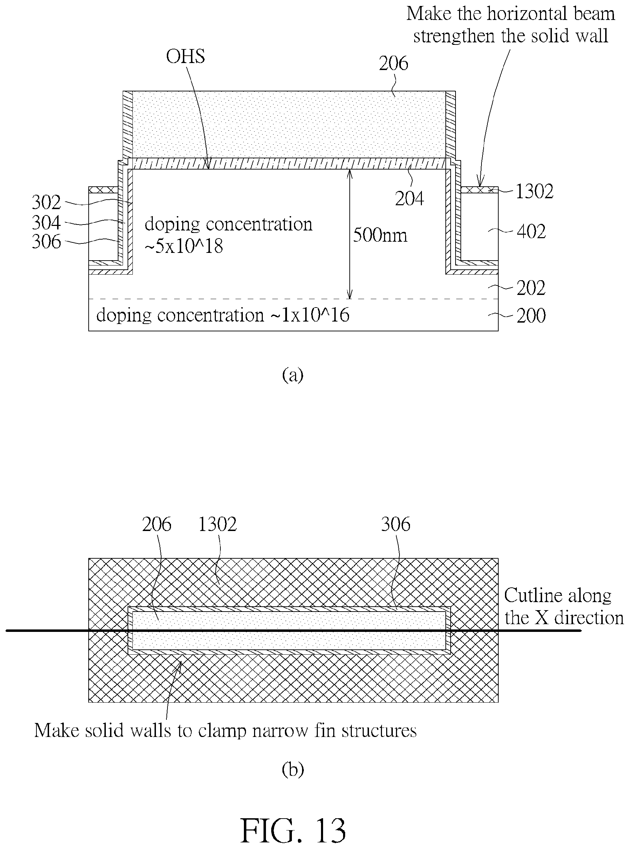

Differences between the second embodiment and the first embodiment are that:
1) In step 1208, as shown in FIG. 13, deposit the thick oxide layer to fully fill the trench 210 and use the CMP technique to remove the excess oxide layer and etch back the oxide layer to form the STI 402, wherein a top surface of the STI 402 is in level up to a specific height lower than the OHS.
2) In step 1210, as shown in FIG. 13, then deposit a proper thickness of the nitride film 1302 on the STI 402. It is noticed that the extension direction (such as horizontal direction) of the nitride film 1302 is different from the extension direction (such as vertical direction) of the nitride spacer 306 which clamps the fin structure, wherein the nitride film 1302 would be a supporting beam to sustain the nitride spacer 306.

Therefore, the second embodiment of present invention provides a composite structure to clamp the fin structure. The composite structure includes a supporting wall (i.e. the semiconductor layer 302, the oxide spacer 304, and the nitride spacer 306) to clamp the fin structure, and the supporting wall extends in a first direction (i.e. the vertical direction) from the bottom of the fin structure. The composite structure further includes a supporting beam (i.e. the nitride film 1302) which extends in a second direction (i.e. the horizontal direction) different from the first direction of the supporting wall. The supporting beam could abut against the supporting wall and sustain the supporting wall, such that the fin structure is further strengthened and prevented from collapse.

Furthermore, the STI 402 (shown in FIG. 13) further encompasses or clamp the active region or the narrow fin structure, especially the sidewalls of the fin structure, to protect the narrow fin structure from collapse during the forming the source/the drain or the gate of the FinFET.

In addition, the purpose of the second embodiment is to make sure more Fin protection for bending effect and falling effect.

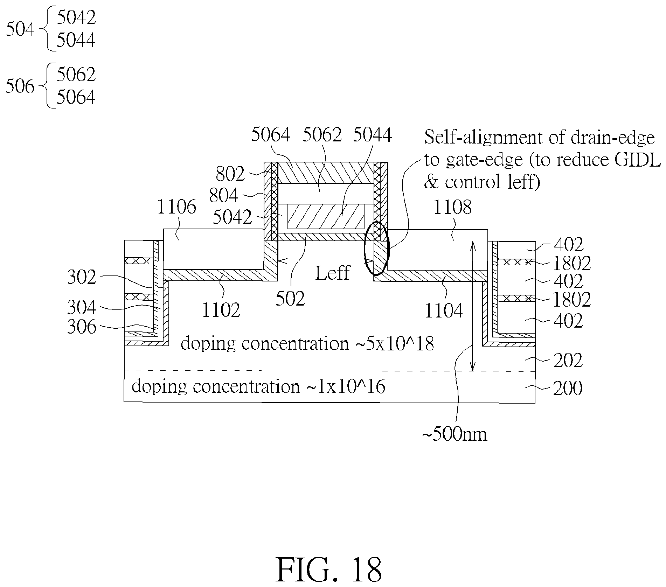

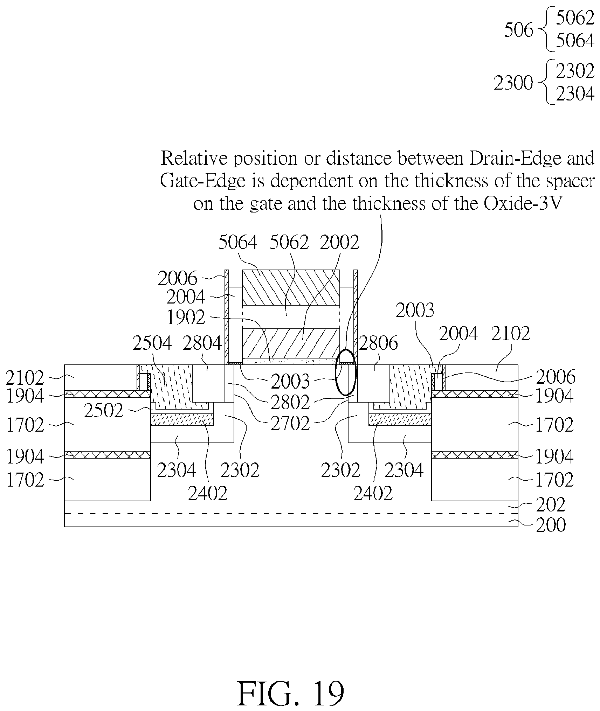

Furthermore, in another embodiment, in Step 1210, a nitride film 1802 could be deposited several times (as shown in FIG. 18). Those multiple deposited nitride films 1802, combining with the nitride spacer, could strengthen the fin structure and prevent the fin structure from collapse. Similarly, in another embodiment, as shown in FIG. 19, a nitride film 1904 could be deposited several times and the resistance of the source/drain region could be improved by forming metal-semiconductor junction in the source/drain region. Furthermore, most the source/drain areas are isolated by insulation materials including the bottom structure by the oxide-3B layer 2304 and/or the nitride-3 layer 2402, the junction leakage can be significantly reduced. In addition, FIG. 19 utilizes a merged semiconductor junction and metal conductor (MSMC) structure (disclosed in U.S. Patent Application No. 17/983,348 and filed on 2022/11/08, the corresponding contents of which is enclosed herein by reference) to form the source and the drain which in case is connected directly to the p-type well 202 of the FinFET, so further description thereof is omitted for simplicity.

As shown in FIG. 19, again (1) the fin structure of the second embodiment (shown in FIGS. 12A, 12B) protected by the solid wall, and (2) relative position or distance between the edge of the source/the drain and the edge of the gate region is controllable, and could be dependent on the thickness of the oxide-3V layer 2302 (and/or the thickness of spacer formed on the edges of the gate region). Moreover, the resistance of the source/the drain could be improved by forming the merged metal-semiconductor junction in the source/the drain, as shown in FIG. 19. Furthermore, most the source/drain areas are isolated by insulation materials including the bottom structure by the oxide-3B layer 2304 and/or the nitride-3 layer 2402, so the junction leakage can be significantly reduced.

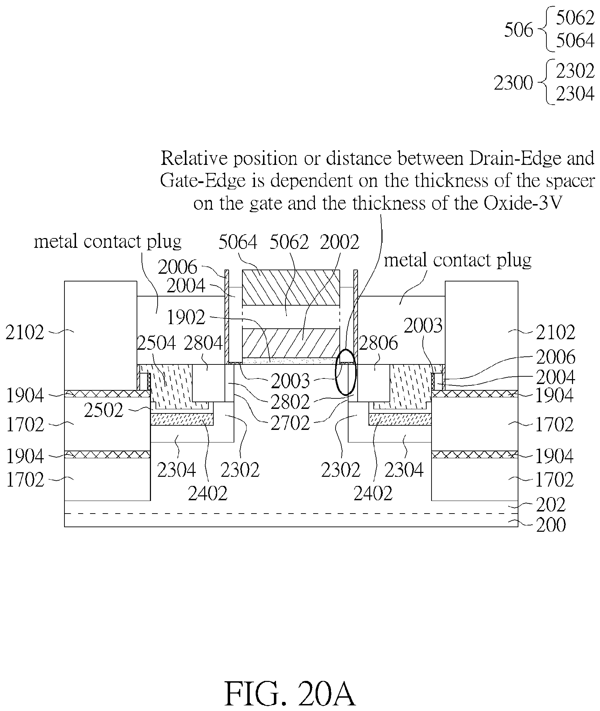

In another embodiment, as shown in FIG. 20A, the top surface of the STI region surrounding the fin structure is higher than the top surface of the fin structure, such that the selectively grown source/drain regions will be confined by the STI region and will not be over the STI region. The metal contact plug can be deposited in the hole between the STI region and the gate region without using another contact mask to create such hole. Moreover, the top, bottom and the sidewall of the source (drain) region is directly contacted to the metal, and the contact resistance of the source/drain regions could be dramatically reduced. Furthermore, it is possible that the bottom of the gate structure on or over the STI region (not shown) surrounding the fin structure could be lower than the bottom of the drain/source region about 10~20nm. In FIG. 20A, the metal material surrounds or contacts top surface, bottom surface and one sidewall of the n+ doped drain 2806.

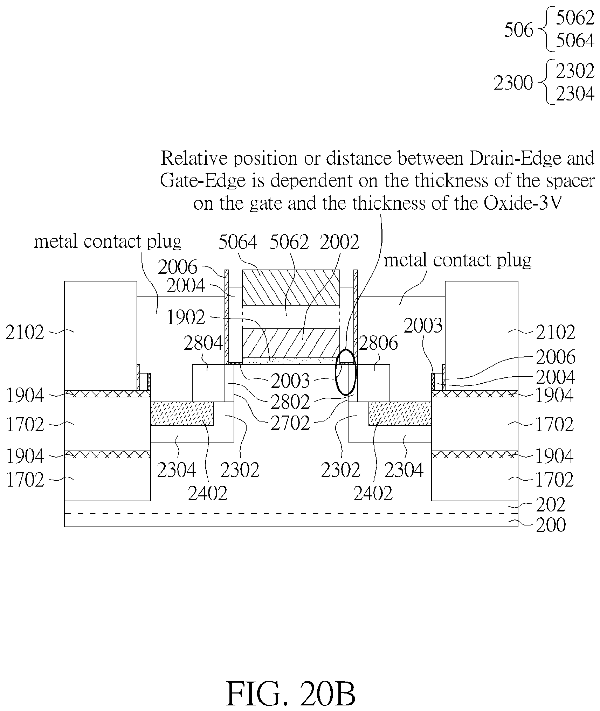

In addition, in another embodiment (as shown in FIG. 20B), a difference between FIG. 20A and FIG. 20B is that the deposited TiN 2502 and deposited metal (e.g. Tungsten 2504) could be omitted, and just use the top surface of the nitride-3 layer 2402 as reference to etch down portion of the oxide-3V layer 2302 to expose silicon sidewall 2702, then utilize the selective growth technique to form an n-type lightly doped drain (NLDD) 2802 and the n+ doped source 2804 and the n+ doped drain 2806, afterward deposit metal like Tungsten (e.g. Tungsten 2504 shown in FIG. 20B). In FIG. 20B, the metal plug contacts top surface and one sidewall of the n+ doped drain 2806.

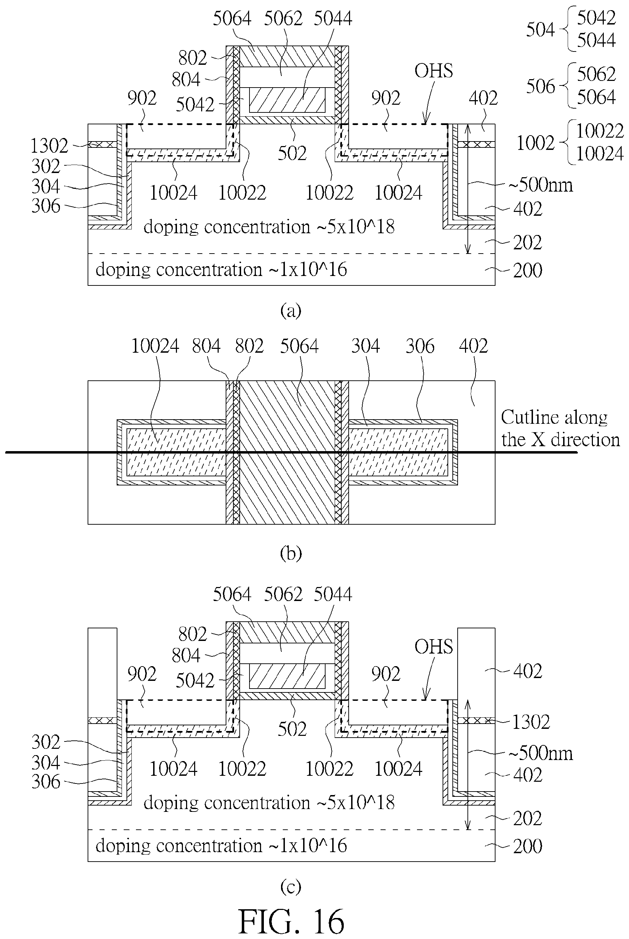

To sum up, the FinFET provided by the present invention has some advantages described as follows:
(1) A solid wall is formed to clamp the active region or the narrow fin structure, especially the sidewalls of the fin structure. Thus, even the height of the fin structure (such as 60~300nm) is far larger than the width of the fin structure (such as 3~7nm), the fin structure protected by the solid wall of the present invention is unlikely vulnerable. Moreover, additional beam-like structure(s) could be provided to strengthen the solid wall.
(2) The relative position or distance between the edge of the source/the drain and the edge of the gate is controllable, and could be dependent on the thickness of spacer formed on the edges of the gate and/or the thickness of the oxide layer (such as the oxide-3V layer in FIG. 7 or FIG. 16).
(3) The gate structure is formed within an etched region with a smooth line edge roughness (FIG. 4), thus, the gate structure has smoother edge.
(4) The resistance of the source/the drain could be improved by forming metal-semiconductor junction in the source/the drain (shown in FIGS. 20A, 20B or FIG. 19).
(5) Most the source/drain areas are isolated by insulation materials including the bottom structure by the oxide-3B layer and/or the nitride-3 layer (shown in FIGS. 20A, 20B or FIG. 19), so the junction leakage current can be significantly reduced.

In addition, technical features shown in FIGS. 20A, 20B or FIG. 19, gate formation described herein, and the above-mentioned advantages (2)-(5) not only can be applied to the FinFET, but can also be applied to other types of transistors (e.g. planer transistor).

In addition, when using the selective growth technique to form the source/drain, it is not limited to LDD and then heavily doped region, a concentration of the selective growth source/drain could be adjustable, from the <110> surface, gradually increased from n- to n+, or n- to n++ to n+, or other gradually changed or step-like changed profile.

## Claims

1. A transistor structure comprising:
a substrate with a fin structure;
**characterized by**:
an isolation wall clamping sidewalls of the fin structure; and
a gate region above the fin structure and the isolation wall;
wherein the isolation wall is configured to prevent the fin structure from collapsing.

2. The transistor structure in claim 1, **characterized in that** the isolation wall clamps four sidewalls of the fin structure.

3. The transistor structure in claim 2, **characterized in that** further comprising a STI layer surrounding the isolation wall.

4. The transistor structure in claim 1, **characterized in that** further comprising a sheet channel layer disposed between the sidewalls of the fin structure and the isolation wall, wherein the sheet channel layer is formed by selective epitaxy growth.

5. The transistor structure in claim 1, **characterized in that** the gate region comprising a gate dielectric layer over the fin structure substrate, a gate conductive layer over the gate dielectric layer, and a cap layer over the gate conductive layer.

6. The transistor structure in claim 5, **characterized in that** the isolation wall is configured to prevent the fin structure from collapsing during the formation of the gate dielectric layer, the gate conductive layer, and the cap layer.

7. The transistor structure in claim 1, **characterized in that** further comprising a spacer layer on a sidewall of the gate region.

8. The transistor structure in claim 7, **characterized in that** the first conductive region is formed in a first concave under an original surface of the substrate.

9. A transistor structure comprising:
a substrate with a fin structure;
**characterized by**:
a composite structure clamping sidewalls of the fin structure; and
a gate region above the fin structure and the composite structure;
wherein the composite structure is configured to prevent the fin structure from collapse.

10. The transistor structure in claim 9, **characterized in that** the composite structure comprises a supporting wall clamping the sidewalls of the fin structure and a supporting beam sustaining the supporting wall.

11. The transistor structure in claim 10, **characterized in that** the supporting wall extends in a first direction from a bottom of the fin structure, and the supporting beam extends in a second direction different from the first direction of the supporting wall.

12. The transistor structure in claim 10, **characterized in that** the supporting wall and the supporting beam are made of nitride.

13. The transistor structure in claim 10, **characterized in that** the supporting beam abuts against the supporting wall.

14. The transistor structure in claim 9, **characterized in that** the composite structure comprises a supporting wall clamping the sidewalls of the fin structure and a plurality of supporting beams sustaining the supporting wall.

15. A transistor structure comprising:
a substrate with an original surface;
a channel region;
a gate region above the channel region;
a shallow trench isolation region;
a first conductive region between the gate region and the shallow trench isolation region, the first conductive region electrically contacting to the channel region; and
**characterized by**:
a metal region between the gate region and the shallow trench isolation region;
wherein at least two sides of the first conductive region contact to the metal region.

16. The transistor structure in claim 15, **characterized in that** the shallow trench isolation region extends upward and above the original surface, and the first conductive region is not over the shallow trench isolation region.

17. The transistor structure in claim 15, **characterized in that** the metal region contacts a top surface and a sidewall of the first conductive region.

18. The transistor structure in claim 15, **characterized in that** further comprising an L shape isolator under a bottom of the first conductive region.

19. A transistor structure comprising:
a substrate with an original surface;
a channel region;
a gate region above the channel region;
a shallow trench isolation region surrounding the channel region; and
a first conductive region electrically contacting to the channel region;
**characterized by**:
wherein a bottom of the gate region is lower than a bottom of the first conductive region.

20. The transistor structure in claim 18, **characterized in that** the bottom of the gate region is over a part of the shallow trench isolation region.
